(19) Europäisches Patentamt
European Patent Office
Office européen des brevets

(11) EP 0 938 526 B1

(12) EUROPEAN PATENT SPECIFICATION

(45) Date of publication and mention of the grant of the patent:
**23.04.2003 Bulletin 2003/17**

(21) Application number: **96942054.6**

(22) Date of filing: **12.11.1996**

(51) Int Cl.⁷: **C09J 163/10**, C08F 283/10, C09J 181/08

(86) International application number:
**PCT/US96/18841**

(87) International publication number:
**WO 98/021287 (22.05.1998 Gazette 1998/20)**

(54) **THERMOSETTABLE PRESSURE SENSITIVE ADHESIVE**

EIN THERMOSTATOPLASTISCHER VORLÄUFER FÜR EINEN DRUCKEMPFINDLICHEN KLEBSTOFF

ADHESIF THERMODURCISSABLE, SENSIBLE A LA PRESSION

(84) Designated Contracting States:
**DE FR GB IT**

(43) Date of publication of application:
**01.09.1999 Bulletin 1999/35**

(73) Proprietor: **MINNESOTA MINING AND MANUFACTURING COMPANY**
**St. Paul, Minnesota 55133-3427 (US)**

(72) Inventors:
- **BENNETT, Greggory, Scott**
  **D-40883 Ratingen (DE)**
- **THYSSEN, Andre, Peter**
  **D-47906 Kempen (DE)**
- **RIEDER-OTTERBURG, Suzanne, Helene**
  **D-41564 Kaarst (DE)**
- **HAAK, Christopher, A.**
  **Oakdale, MN 55128 (US)**
- **KARIM, Naimul**
  **Mapelwood, MN 55119 (US)**

(74) Representative: **Wilhelm, Stefan et al**
**3M Deutschland GmbH**
**Carl-Schurz-Strasse 1**
**41453 Neuss (DE)**

(56) References cited:

| | |
|---|---|
| EP-A- 0 012 542 | EP-A- 0 386 909 |
| WO-A-95/13327 | WO-A-95/13328 |
| WO-A-96/21704 | GB-A- 2 119 810 |
| US-A- 4 199 646 | US-A- 4 552 604 |
| US-A- 5 086 088 | |

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

BACKGROUND OF THE INVENTION

Field of the invention

The present invention refers to a thermally-curable epoxy/acrylate based pressure-sensitive adhesive which has an onset temperature of the epoxy curing reaction of below 100°C and to the photopolymerizable precursor of such adhesive. The present invention furthermore refers to a method for bonding a plastic surface to another surface by using such adhesive and to the assemblies thus obtained. The invention furthermore refers to an assembly comprising two plastic surfaces exhibiting a high overlap shear strength.

Background ofthe invention

Thermosettable epoxy-acrylate based pressure-sensitive adhesives, the acrylate component of which comprises from about 30% to about 80% by weight of a photopolymerizable monomeric or prepolymeric syrup containing an acrylic acid ester of a non-tertiary alcohol, and a moderately polar copolymerizable monomer, have been described in US 5,086,088. The hardener for the epoxide component preferably is an amine hardener, and a curing temperature of, for example, 140°C is applied for 20 or 40 minutes (see Example 41 of US '088). The pressure-sensitive adhesive tapes are proposed for use in the automotive industry. In a specific embodiment which is termed as roof ditch molding, the pressure-sensitive adhesive tape is first applied to the roof molding and fastened to the body of a car. The pressure-sensitive adhesive tape is thermoset in a subsequent curing cycle.

US 4,552,604 relates to a method for bonding together two surfaces selected from the group consisting of metals, ceramics or wood using a thermosettable epoxy/acrylate based pressure-sensitive adhesive which optionally is tacky. The specification discloses a broad range of acrylate components and uses in the examples moderately polar components such as 1-phenoxy-2-hydroxypropyl acrylate and/or crosslinkable acrylates such as di- or triacrylates. The hardener can be polycarboxylic acid anhydride, dicyandiamide, an imidazole, a latent boron difluoride chelate, an aromatic polyamine and a complex of an amine with boron trifluoride or boron trichloride. The adhesive is thermoset at a temperature of, for example, 170°C for 1 hour (see Example 1 of US '604) and was characterized in US 5,086,088 to require a high external pressure or clamping due to the poor internal strength of the uncured adhesive.

WO 95/13,328 which was published on May 18, 1995 describes a thermosettable pressure-sensitive adhesive comprising one or more thermosettable resins and a polymerizable monomeric or prepolymeric syrup of low polarity comprising one or more acrylates and one or more non-polar ethylenically unsaturated monomers. The adhesive is reported to exhibit good adhesion in the thermally cured state to oily cold rolled steel. The thermosettable resins are preferably cured by amine type hardeners at a temperature of, for example, 150°C for 30 min (see WO '328, Test Procedure D).

Copending European patent application 96 105 122.4 which was filed on March 29, 1996, describes an epoxy/acrylate based adhesive comprising a vinyl ester or a vinyl ether type polymer additive in order to improve, for example, the melt-flow behaviour and cold flow properties. The adhesive can comprise nucleophilic hardeners for the epoxy component such as amine-type hardeners or electrophilic hardeners such as organic acids or acid anhydrides. In the test applied for measuring overlap shear the adhesive is thermoset by curing it in a forced air oven at 160°C for 20 minutes.

Bonding of temperature-sensitive substrates such as, for example, plastic substrates requires sufficiently low curing temperatures of the thermosettable resin in order to avoid damaging of the substrate during the curing reaction. The curing temperatures reported in the above references were too high to allow for applying them to low-melting plastic substrates, for example. Additionally, the compositions of US '088 and US '604 are high in polarity which makes them less favourable for bonding of non-polar substrates such as plastics. The acrylate-containing monomeric or prepolymeric syrup described in WO '328, sometimes exhibits a limited solubility for the thermosettable resin, and the mechanical properties of the thermoset adhesive do not always meet all practical requirements to a sufficient and/or desirable degree.

There was therefore a need for providing a thermosettable pressure-sensitive adhesive having an onset temperature of the epoxy curing reaction of not more than 100°C so as to render the adhesive curable at reduced temperatures and/or for reduced times and to facilitate bonding of thermally-sensitive substrates such as plastics.

There was furthermore a need for providing a thermosettable pressure-sensitive adhesive which has good cured-state adhesive properties to low energy surfaces such as plastics and allows for the preparation of assemblies comprising at least one low-surface energy substrate bonded to another substrate with the thermoset adhesive, which exhibits advantageous mechanical properties and, in particular, a high overlap shear strength.

Short description of the invention

The invention relates to the photopolymerizable precursor of a thermosettable pressure-sensitive adhesive said precursor comprising:

(i) from about 30% to about 80% by weight with respect to the mass of the precursor of a photopolymerizable component comprising a monomeric or a prepolymeric syrup said component exhibiting an overall solubility parameter of between 10 and 11 and comprising

(A) at least 30% by weight with respect to the mass of component (i) of one or more ethylenically unsaturated monomers with a solubility parameter of between 10 and 11.5, and less than 10% by weight with respect to the mass of component (i) of one or more ethylenically unsaturated monomers with a solubility parameter of more than 11.5, or

(B) at least 50% by weight with respect to the mass of the photopolymerizable component (i) of one or more ethylenically unsaturated monomers with a solubility parameter of between 9.5 and 11.5 and 10-30% by weight with respect to the mass of the photopolymerizable component (i) of one or more ethylenically unsaturated monomers with a solubility parameter of between 11.5 and 12.5 with the provision that in case (B) the precursor comprises between 3-15% by weight with respect to the mass of the precursor of one or more polymers having a solubility parameter of between 10 to 12.5.

(ii) from about 20 to about 70% by weight with respect to the mass of the adhesive of one or more epoxy resins and/or epoxy-containing monomers,

(iii) an effective amount of one or more photoinitiators, and

(iv) an effective amount of one or more latent nucleophilic hardeners for the epoxy resins and/or epoxy-containing monomers (ii) which are selected to provide an onset temperature of the epoxy curing reaction of between 40-100°C, when subjecting the adhesive to a DSC scan at a rate of 20°C/min, wherein the solubility parameters are calculated in each case according to the Fedors method and are reported in $(cal/cm^3)^{0.5}$.

The invention furthermore relates to a thermosettable pressure-sensitive adhesive which is obtainable by photopolymerization of the precursor and to a method for bonding a plastic surface to another surface comprising sandwiching the thermosettable pressure-sensitive adhesive between the two surfaces with subsequent thermal curing.

The invention furthermore refers to an assembly comprising two plastic surfaces which are bonded with a thermally-cured pressure-sensitive adhesive, the precursor of which comprises a blend of an acrylate-based pressure-sensitive adhesive and one or more thermosettable epoxy resins and/or monomers as defined in present claims 1-4 and is cured at a temperature above the onset temperature of the epoxy curing reaction to give an overlap shear strength of the assembly of at least 3 MPa.

Detailed description of the invention

The present invention refers to a thermosettable pressure-sensitive adhesive which is obtainable by photopolymerization of the corresponding photopolymerizable precursor. The pressure-sensitive adhesive is thermosettable, i.e. can be cured by application of heat to give a thermoset adhesive.

The epoxy/acrylate based thermosettable pressure-sensitive adhesive according to the invention exhibits good adhesion to low energy surfaces and allows for the preparation of assemblies comprising two low energy surfaces or a low energy surface and another surface. Low energy surfaces are defined as polymeric surfaces such as polymethylmethacrylate, polycarbonate, polystyrene and acrylonitrilebutadiene styrene and the like but do not include very low energy surfaces such as polytetrafluoroethylene and polyolefins such as polyethylene. Such assemblies exhibit advantageous mechanical properties and, in particular, a high overlap shear strength. The advantageous mechanical properties are achieved by adjusting the polarity of the photopolymerizable component (i) of the precursor of the thermosettable pressure-sensitive adhesive so that

- the polarity and the dissolution power are low enough, on the one hand, to provide good adhesion of both the uncured and thermally-cured adhesive to low energy surfaces, and
- the polarity and the dissolution power are high enough, on the other hand, to dissolve a sufficiently high amount of the epoxy part (ii) of the thermosettable adhesive so as to provide advantageous mechanical properties of the

thermally cured adhesive.

A sufficiently low polarity and low dissolution power of the photopolymerizable component are also in particular desirable in case the latency of one or more of the hardener compounds is based on solvent effects, crystallinity and/ or encapsulation.

The present inventors found that this balance of properties is obtained in a first embodiment (A) of the precursor of the invention by using a photopolymerizable component (i) of the precursor of the thermosettable pressure-sensitive adhesive which has an overall solubility parameter of between 10 and 11, preferably of between 10.0 and 10.8 and more preferably of between 10.1 and 10.6 and comprises at least 30%, preferably 30-70% and more preferably 35-60% by weight with respect to the mass of the photopolymerizable component (i) of one or more ethylenically unsaturated monomers with a solubility parameter of between 10 and 11.5, preferably between 10.2 and 11.3 and more preferably between 10.3 and 11.2. In embodiment (A), the photopolymerizable component (i) of the precursor of the thermosettable pressure-sensitive adhesive furthermore contains less than 10%, preferably less than 7.5% and more preferably less than 5% by weight with respect to the mass of component (i) of one or more ethylenically unsaturated monomers with a solubility parameter of more than 11.5.

Alternatively, the present inventors have found that the above balance of properties can also be obtained in a second embodiment (B) of the precursor of the invention by using a photopolymerizable component (i) of the precursor of the thermosettable pressure-sensitive adhesive which has an overall solubility parameter of between 10 and 11, preferably of between 10.1 and 10.8 and more preferably of between 10.3 and 10.6 and which comprises

- at least 50% and preferably 55-80% by weight with respect to the mass of the photopolymerizable component (i) of one or more ethylenically unsaturated monomers with a solubility parameter of between 9.5 and 11.5,
- 10-30% by weight with respect to the mass of the photopolymerizable component (i) of one or more ethylenically unsaturated monomers with a solubility parameter of between 11.5 and 12.5, and
- 3-15% by weight with respect to the mass of the precursor of one or more polymers having a solubility parameter of between 10 and 12.5.

The solubility parameters referred to above and below are calculated according to the technique described in Fedors, Polym. Eng. and Sci., 14 (1974), 147. A list of several common ethylenically unsaturated monomers and their respective Fedors' solubility parameters is shown in Table 1 below. The term 'overall solubility parameter' of the photopolymerizable component (i) used above and below, is defined as the sum of the solubility parameters of the different monomers and repeat units of any photopolymerizable prepolymeric, oligomeric or polymeric constituents of component (i) as weighted by the respective percentage by weight of the monomers and repeat units with respect to the sum of the masses of the monomers and the photopolymerizable prepolymeric, oligomeric or polymeric constituents of component (i).

It was surprisingly found that the photopolymerizable component (i) of the precursor of the thermosettable pressure-sensitive adhesive has to exhibit both in embodiment (A) and (B) a medium overall solubility parameter of between 10-11 and preferably of between 10.0 and 10.8 and more preferably of between 10.1 and 10.6.

In embodiment (A) the precursor must additionally comprise at least 30% of one or more ethylenically unsaturated compounds with a medium solubility parameter of between 10-11.5, preferably of between 10.2 and 11.3 and more preferably of between 10.3 and 11.2.

Contrary to this, precursors of thermosettable pressure-sensitive adhesives where the photopolymerizable component (i) meets the requirement of a medium overall solubility parameter by combining strongly polar acrylic compounds with a high solubility parameter with a sufficient amount of essentially unpolar compounds with a solubility parameter of less than 10, while not comprising a substantial amount of one or more ethylenically unsaturated compounds with a medium solubility parameter of between 10 and 11.5, do not have the desired combination of properties.

It was furthermore found that in embodiment (A), the percentage of one or more ethylenically unsaturated compounds with a medium solubility parameter of between 10 and 11.5 has to be at least 30% by weight with respect to the mass of photopolymerizable component (i) of the thermosettable pressure-sensitive adhesive. Below this limit,

- the solubility of the thermosettable epoxy component (ii) of the precursor of the thermosettable pressure-sensitive adhesive may be too low which results in disadvantageous mechanical properties of the thermoset adhesive,
- the adhesion of the photopolymerized thermosettable pressure-sensitive adhesive to low-energy surfaces, in either its uncured or thermally-cured state, may not be sufficient, and/or
- the solubility of the hardener component (iv) in the precursor of the thermosettable pressure-sensitive adhesive below the desired onset temperature of the epoxy curing reaction may be too high which results in disadvantageous shelf-life and stability.

The percentage of the photopolymerizable ethylenically unsaturated compounds with a medium solubility parameter of between 10-11.5% is preferably 30-70%, more preferably 35-60% by weight and especially preferably 35-50% by weight with respect to the mass of the photopolymerizable component (i).

In embodiment (B) the photopolymerizable component (i) of the precursor comprises 10-30% by weight with respect to the mass of component (i) of one or more ethylenically unsaturated monomers with a moderately high solubility parameter of between 11.5 and 12.5 and at least 50% by weight with respect to the mass of component (i) of one or more ethylenically unsaturated monomers with a moderately low or medium solubility parameter of between 9.5 and 11.5.

The photopolymerizable component (i) of the precursor of embodiment (B) often exhibits an advantageous solubility behaviour with respect to the epoxy component (ii) which is due to the presence of a substantial amount of one or more ethylenically unsaturated monomers with a moderately high solubility parameter of between 11.5 and 12.5 in component (i). It was surprisingly found that the solubility of the hardener component (iv) in the precursor can be sufficiently suppressed in spite of the presence of the ethylenically unsaturated monomers with a moderately high solubility parameter in component (i) by adding 3-15% by weight with respect to the mass of the precursor of one or more polymers with a solubility parameter of between 10 to 12.5. The average molecular weight Mw of the polymers is preferably between 50,000 to 500,000 g/mol.

Below the limit of 3% by weight of the polymer additive the solubility of the hardener component in the precursor is too high which results in disadvantageous shelf-life and stability in case the latency of one or more of the hardener compounds is based on solvent effects, crystallinity and/or encapsulation. Above the limit of 15% by weight of the polymer additive, the viscosity of the precursor typically is too high which results in disadvantageous handling properties.

Above and below the term ethylenically unsaturated monomers refers to compounds comprising one or more groups

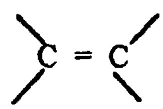

Ethylenically unsaturated monomers useful in the present invention include but are not limited to (meth)acrylic esters of non-tertiary alcohols and N-bearing compounds comprising one or more ethylenical groups

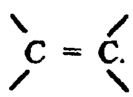

Photopolymerizable component (i) of embodiment (A)

The ethylenically unsaturated monomers with a solubility parameter of between 10-11.5 of the photopolymerizable component (i) of embodiment (A) preferably are acrylates. These are preferably selected from a group consisting of monofunctional acrylic or methacrylic esters of a non-tertiary alcohol such as tetrahydrofurfuryl acrylate, methyl acrylate, 2-phenoxyethyl-acrylate and benzyl acrylate. Especially preferred is a smaller group of monofunctional acrylic or methacrylic esters of a non-tertiary alcohol with a medium solubility parameter comprising compounds with one or more ether groups -O- such as, for example, 2-phenoxyethyl acrylate or tetrahydrofurfuryl acrylate.

The photopolymerizable acrylate compounds with a medium solubility parameter of between 10-11.5 preferably have a glass transition temperature of the corresponding homopolymer of between -20°C and 40°C and, more preferably, of between -10°C and 30°C.

The photopolymerizable component (i) embodiment (A) preferably additionally comprises at least 15% by weight and more preferably at least 20% by weight with respect to the mass of component (i) of one or more monofunctional acrylic or methacrylic esters of a non-tertiary alcohol exhibiting a solubility parameter of less than 10 and more preferably of between 9.5 and 10. Examples of such compounds are octadecyl acrylate, lauryl acrylate, 2-ethylhexyl acrylate, butyl acrylate or isobornyl acrylate. The amount of such compounds is preferably between 15-70% by weight with respect to the mass of component (i), more preferably between 20-60% and, in particular, between 20-50% by weight with respect to the mass of component (i).

Although the properties of the precursor of the thermosettable pressure-sensitive adhesives and of the photopolymerized adhesive according to embodiment (A) are sensitive to the addition of polar copolymerizable monomers with a Fedors solubility of more than 11.5, especially of more than 12.5 and, in particular, of more than 13, a small amount of less than 10%, and more preferably of not more than 7.5% by weight with respect to the mass of the photopolymerizable component (i) of the precursor may occasionally be added to improve the solubility of the epoxy component (ii) of the precursor in the photopolymerizable component (i).
Copolymerizable monomers with a Fedors solubility of more than 13 should not be added in an amount of more than 5% and more preferably not more than 3% by weight with respect to the mass of component (i) of the precursor. Preferred examples of a suitable strongly polar acrylate monomer are butoxy acrylate and N-vinylcaprolactam.

Although component (i) of embodiment (A) is preferably acrylate-based, i. e. preferably contains at least 50% by weight with respect to the mass of component (i) of one or more acrylic esters of non-tertiary alcohols, it may also comprise other ethylenically unsaturated copolymerizable monomers, oligomers and/or polymers comprising one or more groups

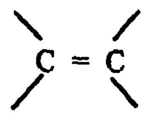

Examples of preferred non-acrylate copolymerizable monomers having a solubility parameter of between 10 and 11.5 are N-octyl acrylamide and vinyl acetate and, in particular, N-octyl acrylamide.

Examples of suitable non-acrylate copolymerizable monomers with a solubility parameter of more than 11.5 are N-vinyl caprolactam, N,N-dimethylacrylamide and butoxy acrylate.

Component (i) of embodiment (A) can also comprise co-photopolymerizable oligomers or polymers such as, for example, macromonomers.

In an especially preferred embodiment the compounds of component (i) of embodiment (A) are selected so that the polymer obtained by photopolymerization of component (i) has a glass transition temperature of between 250 K and 345 K, more preferably of between 270 and 335 K and especially preferably of between 295 and 320 K. The glass transition temperature $T_g$ of the photopolymerized component (i) can be well estimated by using the so-called Fox equation

$$1 / T_g = \sum_n X_n (1/T_{g,n})$$

wherein $T_{g,n}$ is the glass transition temperature of the homopolymer of the n-th ethylenically unsaturated monomer or ethylenically unsaturated repeat unit of any photopolymerizable prepolymeric constituent, respectively, of the photopolymerizable component (i) and $X_n$ is the mole fraction of the n-th ethylenically unsaturated monomer or ethylenically unsaturated repeat unit of any prepolymeric constituent, respectively, with respect to the photopolymerizable component (i). All temperatures are specified in degrees Kelvin. A full description of $T_g$ calculations based on the Fox equation can be found in Makromolekuele, 5th Ed. by Hans-Georg Elias (Huethig & Wepf, 1990), p.856.

The photopolymerizable component (i) of the precursor of the thermosettable pressure-sensitive adhesive according to embodiment (A) can be unpolymerized or partly prepolymerized and can furthermore comprise copolymerizable oligomers or polymers such as, for example, copolymerizable macromonomers. Partial prepolymerization can be effected by either thermal or photochemical methods. The photopolymerizable component (i) is mixed with an initiator and the polymerization of the monomers conducted to low conversion. In cases where component (i) is partially prepolymerized, initiation is preferably conducted with a part of the photoinitiator component (iii). The premix of (i) and part of (iii) is then partially prepolymerized to a syrup exhibiting a room temperature viscosity in the range from about 100 to about 20,000 cps and, more preferably, from about 300 to 5,000 cps. The weight percentages given above and below for ethylenically unsaturated monomers comprise both unreacted and partially prepolymerized ethylenically unsaturated monomers.

Photopolymerizable component (i) of embodiment (B)

The ethylenically unsaturated monomers with a solubility parameter of between 9.5 and 11.5 of the photopolymerizable component (i) of embodiment (B) preferably are acrylates. These are preferably selected from a group consisting of monofunctional acrylic or methacrylic esters of a non-tertiary alcohol such as isobutyl acrylate, butyl acrylate, propyl acrylate, ethyl acrylate, iso-bornyl acrylate, tetrahydro-furfuryl acrylate, methyl acrylate and 2-phenoxyethyl acrylate. The ethylenically unsaturated monomers have a solubility parameter of between 9.5 and 11, more preferably of between 9.5 and 10.5 and especially preferably of 9.5 and 10. Especially preferred is a smaller group of monofunctional acrylic esters comprising butyl acrylate, propyl acrylate and iso-bornyl acrylate.

The photopolymerizable component (i) of the precursor of the thermosettable pressure-sensitive adhesive according to embodiment (B) additionally comprises from 10 to 30% and preferably from 10 to 20% by weight with respect to the mass of component (i) of one or more copolymerizable ethylenically unsaturated monomers having a solubility parameter of between 11.5 and 12.5 and preferably of between 12 - 12.5 to improve the solubility of the epoxy component (ii) of the precursor in the photopolymerizable component (i). Examples of preferred copolymerizable monomers with a solubility parameter of between 11.5 and 12.5 are N-vinyl caprolactam and N,N-dimethylacrylamide.

The photopolymerizable ethylenically unsaturated monomers with a solubility parameter of between 9.5 and 11.5 and 11.5 and 12.5 are preferably selected so that the corresponding copolymer of these monomers has a glass transition temperature of between -60 and 40°C.

The precursor of the thermosettable pressure-sensitive adhesive according to embodiment (B) additionally comprises from 3 to 15% and preferably 3 to 10% by weight with respect to the mass of the precursor of one or more polymers having a solubility parameter of 10 to 12.5. The polymers can be added to the photopolymerizable component (i) or included when combining components (i)-(iv) to obtain the precursor; the polymer should, however, preferably be added prior to adding the hardener component (iv). It was found that the addition of such polymers to the precursor of embodiment (B) distinctly reduces the solubility of the hardener component (iv) in the precursor. Advantageously, the addition of such polymers to the precursor according to embodiment (B) allows for incorporation of higher levels of ethylenically unsaturated monomers with a moderately high solubility parameter of between 11.5 and 12.5 into the photopolymerizable component (i) resulting in cured thermosettable pressure-sensitive adhesives possessing excellent internal strength and other desirable mechanical properties. Although the present inventors do not wish to be bound by such theory it is postulated that these advantageous properties can also be attributed to the enhanced compatibility of the epoxy component(ii) and the photopolymerizable component (i) in the precursor of the thermosettable pressure-sensitive adhesive provided by these polymers having a medium to moderately high solubility parameter.

A wide range of polymers having the required range of the solubility parameter of between 10 and 12.5 can be used. Polymers with a solubility parameter of less than 10 were often found to exhibit an insufficient compatibilty with the epoxy component (ii), whereas polymers with a solubility parameter of more than 12.5 typically exhibit an insufficient solubilty in the photopolymerizable component (i). Additionally, the polymers should have a relatively low molecular weight Mw of, for example, between 50,000 - 500,000 g/mol and should be essentially uncrosslinked in order to enhance the solubility of the polymer in the precursor or the photopolymerizable component (i), respectively. The polymer additives should furthermore be preferably essentially "dead", i.e. free or basically free from unsaturated or chain transferring groups in order to avoid crosslinking or chain transfer reactions with component (i) of the precursor.

Examples of preferred polymers are those that comprise units of formula I

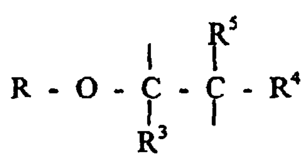

I

Above and below polymers comprising units of formula I are also termed as polymers of formula I.

R is preferably $R^1$-CO- with $R^1$ being preferably methyl, ethyl, propyl, butyl, pentyl, methoxy, ethoxy, propoxy or partially or fully halogenated methyl. R especially preferably denotes $CH_3$-CO-. Polymers comprising units of formula I wherein R is $R^1$-CO- are termed below and above as vinyl ester type polymers.

R can also be $R^2$ with $R^2$ being preferably methyl, ethyl, propyl, butyl or pentyl. Polymers comprising units of formula I wherein R is $R^2$ are termed below and above as vinyl ether type polymers.

$R^3$, $R^4$ and $R^5$ are preferably independently from each other hydrogen, methyl or ethyl. One of $R^3$, $R^4$ and $R^5$ may also preferably be methoxy, ethoxy, propoxy, partly or fully halogenated methyl or a fluoro or chloro group.

The polymer comprising units of formula I may be a homopolymer or a copolymer of two or more comonomers. The polymer used in the precursors according to the invention preferably comprises at least 60% and more preferably

at least 80% by weight of one or more units of formula I.

Especially preferred vinyl ester type polymers are vinyl acetate polymers which are usually obtained by radical emulsion polymerization (see Houben-Weyl, Methods of Organic Chemistry, Macromolecular Materials, Part I, Thieme Publishers, Stuttgart). Suitable comonomers to be used in emulsion copolymerization with vinyl acetate (VA) are, for example, ethylene, dibutyl maleate, bis (2-ethylhexyl) maleate, ethylacrylate, butyl acrylate, N-vinyl pyrrolidone, 2-ethylhexyl acrylate or vinyl laurate. The properties of polyvinylacetate (PVA) or polyvinylacetate (PVAC) can furthermore be modified by grafting during polymerization (see Encyclopedia of Polymer Science and Engineering, New York, 1989, vol. 17, pp. 410 - 411).

Suitable polymers of formula I are commercially available. Copolymers of N-vinyl pyrrolidone and vinyl acetate are available, for example, from International Specialty Products, Lombard, Il., U.S.A., as grades E-335, E-535, E-635, I-335, I-535 or S-630. The NVP/VA ratio varies for these grades between 70/30 and 30/70 and the solubility parameter is between 11.41 and 12.25. KA-8479 is an ethylenvinylacetate with a vinyl-acetate content of about 80% which is commercially available from Bayer AG, Germany.

Other suitable polymers include, for example, phenoxy resins such as Paphen™ phenoxy resin which is commercially available from Phenoxy Associates, Rock Hill, SC, U.S.A. The solubility parameter of this resin is 11.36, and the molecular weight Mw is 50,000 - 60,000 g/mol.

Useful are also N-vinylpyrrolidene alpha-olefin copolymers like those available as Gantrez™ from International Specialty Products, Lombard, Il. These Gantrez polymers have solubility parameters of between 11 and 12.5.

Other preferred polymers are mentioned in the Examples.

The polymer or polymers are preferably selected so that they are compatible with the photopolymerizable component (i) and so that a polymer being obtainable by polymerization of component (i) including the polymer or polymers, has a glass transition temperatute of between -20 and 40 °C. In an especially preferred embodiment the compounds of component (i) are selected so that the polymer obtained by photopolymerization of component (i) including the polymer or polymers, has a glass transition temperature of between 230 and 345 K, more preferably of between 240 and 335 K and especially preferably of between 240 and 320 K. The glass transition temperature of the photopolymer component (i) including the polymer(s) can be estimated by using the Fox equation mentioned above.

It is to be understood that other polymers can be used and that the polymer of formula I and the specific polymers listed above illustrate the invention.

Component (i) of embodiment (B) can also comprise copolymerizable oligomers or polymers such as, for example, macromonomers.

The photopolymerizable component (i) of embodiment (B) can be unpolymerized or partly prepolymerized as described above for embodiment (A). The photopolymerizable component of embodiment (B) is, however, preferably unpolymerized. Its viscosity can be modified if desired by dissolving part or all of the polymer additive with a solubility parameter of between 10 and 12.5. The weight percentages given above and below for ethylenically unsaturated monomers comprise both unreacted and partially prepolymerized ethylenically unsaturated monomers, if any.

<u>Epoxy component (ii)</u>

Organic epoxy compounds useful in the epoxy component (ii) of the precursor of the invention are any organic compounds having an oxirane ring polymerizable by ring opening. Such materials, broadly called epoxides, include monomeric epoxy compounds and epoxides of the polymeric type and can be aliphatic, aromatic or heterocyclic. Monomeric and oligomeric epoxy compounds preferably have at least two and more, preferably two to four, polymerizable epoxy groups per molecule. In polymeric type epoxides or epoxy resins, there may be many pendent epoxy groups (e.g., a glycidyl methacrylate polymer could have several thousand pendent epoxy groups per average molecular weight). Oligomeric epoxides and, in particular, polymeric epoxy resins are preferred.

The molecular weight of the epoxy-containing materials (ii) may vary from low molecular weight oligomeric materials with a molecular weight, e.g., from about 500 to polymeric resins with a molecular weight of about 50,000 or more and may vary greatly in the nature of their backbone and substituent groups. For example, the backbone may be of any type, and substituent groups thereon can be any group not having a nucleophilic group or electrophilic group (such as an active hydrogen atom) which is reactive with an oxirane ring. Illustrative of permissible substituent groups are halogens, ester groups, ethers, sulfonate groups, siloxane groups, nitro groups, amide groups, nitrile groups, phosphate groups, etc. Mixtures of various epoxy-containing materials can also be used in the epoxy part (ii) of the precursor of this invention. The epoxy component (ii) preferably comprises a mixture of two or more epoxy resins in order to modify and control the mechanical properties of the thermoset adhesive.

The term "epoxy resin" is used herein to mean any of dimeric, oligomeric or polymeric epoxy materials containing a plurality, i.e. at least 2, of epoxy functional groups. Types of epoxy resins that can be used include, for example, the reaction product of bisphenol A and epichlorohydrin, the reaction product of phenol and formaldehyde (novolac resin) and epichlorohydrin, peracid epoxies, glycidyl esters, the reaction product of epichlorohydrin and p-amino phenol,

the reaction product of epichlorohydrin and glyoxal tetraphenol and the like. Cycloaliphatic epoxies are less preferred

Suitable commercially available diglycidic ethers of bisphenol-A are Ciba Geigy Araldite ™ 6010, Dow Chemical DER ™ 331, and Shell Chemical Epon ™ 825, 828, 826, 830, 834, 836, 1001, 1004, 1007, etc.

A polyepoxidized phenol formaldehyde novolac prepolymer is available from Dow Chemical as DEN ™ 431 and 438 and from Ciba Geigy as CY-281 ™, and a polyepoxidized cresol formaldehyde novolac prepolymer is available from Ciba Geigy as ECN™ 1285, 1280 and 1299.

A polyglycidyl ether of polyhydric alcohol is available from Ciba Geigy, based on butane-1,4-diol, as Araldite ™ RD-2; and from Shell Chemical Corporation based on glycerine, as Epon ™ 812.

Suitable commercially available flexible epoxy resins include polyglycol diepoxies, DER ™ 732 and 736, from Dow Chemical Company, diglycidyl ester of linoleic dimer acid, Epon ™ 871 and 872 from Shell Chemical Company, and diglycidyl ester of a bisphenol in which the aromatic rings are linked by a long aliphatic chain, Lekutherm ™ X-80, from Mobay Chemical Company.

High functional epoxy resins (i.e. functionality greater than 2) which can be used include, for example, a solid epoxy novolac resin, DEN ™ 485 from Dow Chemical Company, a tetrafunctional solid epoxy resin, Epon ™ 1031 from Shell Chemical Company, and N,N,N',N'-tetraglycidyl-4,4'-methylenebisbenzenamine, Araldite ™ MY 720 from Ciba Corporation. Another example of a tetrafunctional epoxy resin which can be used is N,N,N',N'-tetraglycidyl ether alpha, alpha'-bis(4-aminophenyl)-p-diisopropylbenzene which is commercially available as HPT™1071. An example of a difunctional epoxy resin which can be used is the diglycidyl ether of 9,9-bisphenol fluorene which is commercially available as HPT™ 1079. An example of a trifunctional epoxy resin which can be used is the triglycidyl ether of paraaminophenol which is commercially available as Araldite™ 0500/0510.

The amount of the epoxy component (ii) in the precursor of the thermosettable pressure-sensitive adhesive according to the invention preferably varies from about 20 to about 70% and more preferably from about 30 to about 60% by weight with respect to the mass of the precursor. The epoxy component (ii) is chosen so that it is largely soluble in the photopolymerizable component (i) at room temperature without any macroscopic phase separation. Phase separation is known to contribute to loss of pressure-sensitive adhesive properties of the thermally uncured adhesive.

It was surprisingly found that the photopolymerizable component (i) of the adhesive of the invention dissolves a wide range of epoxy resins at high concentrations of 50% by weight or more based on the overall mass of the precursor.

Photoinitiator component (iii)

The precursor of the pressure-sensitive adhesive of both embodiments (A) and (B) furthermore comprises as component (iii) an effective amount of one or more photoinitiators. The photoinitiator component is preferably present in an amount from about 0.01 to about 5% by weight with respect to the mass of the photopolymerizable component (i). Any conventional free radical photoinitiator activatable by, for example, ultraviolet light may be used. Photoinitiators which are useful in the precursor of the present invention, include benzoin ethers such as benzoin methyl ether of benzoin isopropyl ether, substituted benzoin ethers such as 2-methyl-2-hydroxylpropiophenone, aromatic sulfonyl chlorides such as 2-naphtalenesulfonyl chloride, and photoactive oxides such as 1-phenyl-1, 1-propanedione-2-(o-ethoxy carbonyl)oxime. An example of a commercially available photoinitiator is Irgacure™ 651 available from Ciba-Geigy Corporation, having the formula 2,2-dimethoxy-1,2-diphenylethane-1-one.

Latent nucleophilic hardener component (iv)

The precursor of the thermosettable pressure-sensitive adhesives according to the present invention comprises one or more latent nucleophilic hardeners for the epoxy component (ii) which react with the oxirane ring of the epoxy compounds of component (ii) in an effective amount to cause cross-linking of the epoxy component (ii). It is an essential feature of the present invention that the hardener compounds are latent and that they are selected to provide when subjecting the photopolymerized thermosettable pressure-sensitive adhesive to a DSC scan at a rate of 20°C/min, an onset temperature of the epoxy curing reaction of between 40-100°C.

The term "latent" means that the hardener compound is essentially unreactive at room temperature, but reacts rapidly to effect curing once the onset temperature of the epoxy curing reaction has been exceeded. The onset temperature, which is measured by the method cited under test methods, is between 40 and 100°C, preferably between 40 - 90°C and more preferably between 40-80°C. Rapid reaction means that the epoxy curing reaction is completed to a degree of at least 80% of full curing within 2 hours, preferably within 1 hour and more preferably within 30 minutes or less when subjecting the photopolymerized, thermosettable adhesive to a temperature of about 10°C above the onset temperature.

The lower limit of 40°C is chosen to allow for convenient handling of the thermosettable pressure-sensitive adhesive at room temperature, whereas the upper limit of 100°C ensures that the thermosettable pressure-sensitive adhesive of the present invention can be used for bonding plastic substrates.

The hardener compounds used in the present invention are nucleophilic and heat-activatable and preferably contain one or more nitrogen atoms with at least one active hydrogen atom. Latency of the hardener compounds is preferably based on solvent effects and the activity of the hardener compounds can be controlled, for example, by crystallinity, solubility or encapsulation. In the case of crystallinity effects, the hardener compounds are added to the thermosettable pressure-sensitive adhesive in the form of small solid crystalline particles. The curing reaction is retarded by the crystalline nature of the hardener compounds, which prevents the curative from being dissolved in the epoxy component (ii). The onset temperature thus usually corresponds to a temperature slightly greater than the melting temperature of the hardeners. The hardener may also exhibit a very low solubility in the thermosettable pressure-sensitive adhesive at room temperature which drastically increases at higher temperatures. It has also been suggested to encapsulate the hardener compounds within other materials such as, for example, meltable waxes, meltable polymers or frangible or dissolvable encapsulating agents so that the hardener compounds are physically separated from the epoxy component (ii) of the precursor below the onset temperature of the epoxy curing reaction. The encapsulating material is molten upon heating thus releasing the hardener compound into the precursor.

In a preferred embodiment, the hardener component (iv) comprises one or more crystalline hardener compounds which

- exhibit a melting temperature of between 40 and 80°C and more preferably of between 50 and 70°C,
- are insoluble in the precursor of the embodiment (A) or (B) at room temperature or slightly elevated temperatures, and
- are soluble in the precursor of embodiments (A) or (B) at temperatures above the melting point and effect rapid thermal curing.

Especially preferred are the commercially available hardeners Ancamine™ A 2337XS and A 2014 FG.

It has also been suggested, for example, in US 5, 310, 840 to use electrophilic, UV-activatable hardener compounds for curing acrylate/epoxy based systems. These hardener compounds are disadvantageous because they have to be added to the thermosettable pressure-sensitive adhesive after the photopolymerization of component (i) has been carried out and, in addition, they must be UV-active before the thermal curing can be carried out.

The degree of latency is reflected in the shelf-life of the thermosettable pressure-sensitive adhesives. The percentage of remaining epoxy curing reaction preferably is at least 80%, more preferably at least 90% after 8 weeks, more preferably at least 80% after 20 weeks and especially preferably at least 80% after 1 year of storage at room temperature. The advantageous shelf-life and storage times are due to the composition of the photopolymerizable component (i) which exhibits a moderate overall solubility parameter of between 10 and 11 and is essentially based on compounds with a moderate solubility parameter of between 10 and 11.5.

The degree of curing of the adhesive can be measured and the percentage of the remaining epoxy cure reaction estimated by standard differential scanning calorimetry techniques such as those described in Thermal Characterization of Polymeric Materials, Edith A. Turi, Ed. (Academic Press, 1981), in particular, in Chapter 5, "Thermosets", pp 435-563.

The latent hardener compounds which are useful in the present invention are preferably selected from a group of compounds according to formula II

$$R - X_i \qquad \text{II}$$

wherein R is a mono- or multivalent organic residue, $X_i$ is, independently from one another, a linear or branched alkyl group with at least 8 C atoms wherein at least one of the $-CH_2-$ groups is replaced with a -NH- group and/or which exhibits a terminal N-containing group which contains at least one active H atom and i is an integer from 1-4.

R preferably comprises at least one cycloaliphatic or aromatic ring which optionally may comprise hetero atoms. R preferably comprises at least one benzene ring. The molecular weight of the organic residue R preferably is between 62 and 450. Especially preferred is the following smaller group of organic residues according to formula III

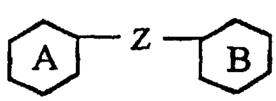

III

wherein

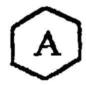

is optionally substituted mono- or multivalent cyclohexane, benzene or naphthalene,

Z is a single bond or a linear or branched alkyl group with up to 6 C atoms wherein one or more $CH_2$- groups may be replaced with -O- or -CO- with the proviso that two O atoms are not directly linked, and

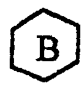

is optionally substituted mono- or multivalent benzene. The valences on groups A and B are not shown.

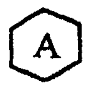

preferably is a mono- or multivalent benzene or naphthalene, and Z preferably is a single bond or $-(CH_2)_n-$ or $-(CH_2)_o-$COO- $(CH_2)_p-$, with n being 1, 2, 3 or 4, o and p being independently 0, 1, 2, 3 or 4 and o + p being 1, 2, 3, 4, 5 or 6.

$X_i$ preferably independently from one another comprises at least 8 and more preferably at least 10 $CH_2$ groups which may be substituted independently from each other with hydroxyl and halogen, and which may be replaced with -O-, -CO-,-NH- or N alkyl- with the proviso that two O or two N atoms are not directly linked.

Especially preferred are the following compounds according to formula IV

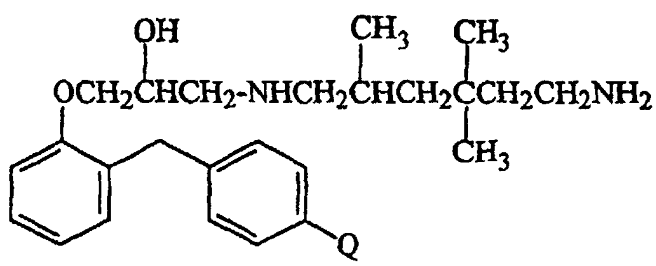

IV

wherein

Q is

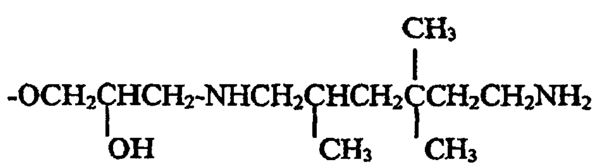

or

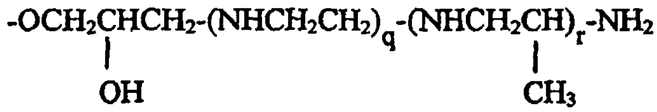

and q and r independently are 1, 2, or 3 and q + r is 1, 2, 3, 4 or 5.

The compounds of formulae II or IV can be obtained by conventional methods. The compounds of formula IV can be obtained, for example, by reacting an aliphatic amine of formula

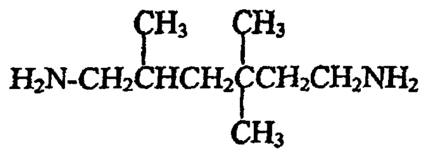

with an epoxy compound or formula

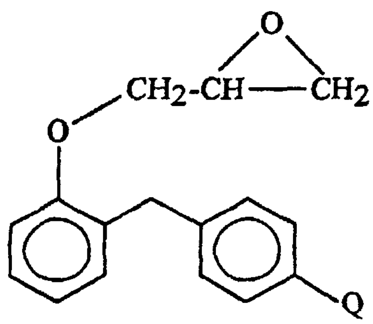

Similar reaction schemes can be applied to obtain the compounds of formula II.

A compound according to formula IV is commercially available from Air Products, Manchester, U.K. as Ancamine 2337 XS.

Other suitable latent nucleophilic hardeners are commercially available from Ciba Geigy, Switzerland, as HT 939 and from Air Products as Ancamine A 2014 FG. HT 939 is a latent modified polyamide hardener.

The amount of the hardener component (iv) required to effect substantially complete hardening of the epoxy component (ii) within a desired length of time, depends on the specific hardener compounds and the epoxy component (ii) used. The amount of the hardener component (iv) preferably varies between 2 and 50%, more preferably between 5 and 50% and especially preferably between 8 and 50% by weight based on the mass of the adhesive. Typically, a mass ratio of epoxy component (ii) to hardener component (iv) of from 0.5 to 10 and more preferably from 1 to 5 is employed. The curing time mainly depends on the amount of the hardener component (ii) and on the curing temperatures employed. Using curing temperatures in the temperature range of 40-100°C, the curing time may be up to two hours. At temperatures of 85 °C, for example, curing times of typically 30 to 60 minutes or less may be applied. The curing time is defined as the time for which 80% or more of the curing reaction has been completed.

The curing times can be considerably decreased by increasing the curing temperature of the epoxy component to higher temperatures, such as, for example, 100 - 250°C. The greater the difference between the curing temperature applied and the onset temperature of the epoxy curing reaction, the more the curing time will be reduced. It was found that curing times of 30 seconds or less can be obtained when using differences between the actual curing temperature and the onset temperature of the epoxy curing reaction of typically about 100°C or more and more preferably of about 125°C or more.

The selection of the actual curing temperature depends on the thermal sensitivity of the substrates to be bonded. When using oven curing the curing temperature of polymeric substrates is typically selected to be less than 100°C and, more preferably, not more than 90°C whereas metallic substrates, for example, allow for higher curing

temperatures. With other curing techniques, higher curing temperatures may also be applied to polymeric substrates. Copending European patent application no. 96 112 715.6 filed on August 7, 1996, by Minnesota Mining and Manufacturing Company, U.S.A., describes a hand-held device for adhering, for example, anchoring devices such as metal buttons having a thermosettable adhesive layer, to a substrate using curing temperatures of the thermosettable adhesive layer of up to 300°C. It was found by the present inventors that this device can be used to apply, for example, aluminum buttons like those of Fig. 4 of copending EP '715 to plastic substrates such as polycarbonate or polymethacrylate substrates using a hot bar plate temperature of this device of between 180 and 300°C and contact times of 10 seconds or less. These contact times at the respective hot bar plate temperatures are high enough to result in high overlap shear strengths between the aluminum button and the plastic substrate, and they are low enough not to damage the plastic substrate to an unacceptable degree.

The hardener component (iv) comprises one or more hardener compounds, preferably between 1-3 and more preferably 1 or 2 hardener compounds.

The precursor of the thermosettable pressure-sensitive adhesives may also comprise accelerators which are used to increase the rate of the epoxide curing reaction without essentially affecting the onset temperature. Particularly preferred accelerators are, for example, imidazoles which often tend to extend the shelf-life of the thermosettable pressure-sensitive adhesive of the invention. Examples of suitable imidazoles include 2,4-diamino-6-(2'-methyl-imidazoyl)-ethyl-S-triazine isocyanurate; 2-phenyl-4-benzyl-5-hydroxymethylimidazole; and micronized hexakis (imidazole) nickel phthalate.

Optional components and additives

The photopolymerizable component (i) of the precursor of the thermosettable pressure-sensitive adhesive of both embodiments (A) and (B) may also contain a small amount of one or more crosslinking agents. The addition of crosslinking agents tends to impede tackiness of the photopolymerized thermosettable adhesive, but typically also increases its stiffness which facilitates, for example, handling of sheet-like material. Consequently, the amount of crosslinking agents is preferably selected in view of the intended application. The amount of the crosslinking agents is, however, preferably not more than 1% by weight with respect to the mass of the photopolymerizable component (i) and varies more preferably between 0 and 0.5% by weight with respect to the mass of the photopolymerizable component (i).

Useful crosslinking agents are those that are free-radically polymerizable with acrylate monomers such as, for example, divinyl ethers, multi-functional acrylates or methacrylates or crosslinkers comprising at least one acrylate group and at least one epoxy group. Examples of multi-functional photoinitiators include multifunctional (meth)acrylates such as, for example, 1,6-hexanediol diacrylate, tri-methylol-propane triacrylate, pentaerythritol tetraacrylate, and 1,2-ethylene glycol diacrylate, urethane di-, tri- and higher functional (meth)acrylates and other organic materials comprising more than one free radically polymerizable double bond.

Where a foam-like photopolymerized, thermosettable pressure-sensitive adhesive tape is desired, the precursor of the pressure-sensitive adhesive of both embodiments (A) and (B) may comprise polymeric microspheres. Suitable microspheres are commercially available from Kema Nord Plastics under the trade name "Expancel" and from Matsumoto Yushi Seiyaku under the trade name "Micropearl". When expanded the microspheres have a specific density of approximately 0.02 - 0.036 g/cc. It is possible to include the unexpanded microspheres in the pressure-sensitive adhesive composition and subsequently heat them to cause expansion when they are appropriately processed, but it is generally preferred to mix the expanded microspheres into the adhesive. This process makes it easier to ensure that the hollow microspheres in the final adhesive are substantially surrounded by at least a thin layer of adhesive. Polymeric microspheres having an average diameter of 10 to 200 µm may be blended into the polymerizable composition in amount from about 15% to about 75% by volume prior to coating.

Also useful are glass microspheres having an average diameter of from 5 to 200 µm, preferably from about 20 to 80 µm. Such microspheres may comprise 5% to 65% by volume of the pressure-sensitive adhesive. Both polymeric and glass microspheres are known in the art. Useful polymeric microspheres are, for example, core/shell fillers comprising a low Tg core polymer and a shell polymer which is compatible with the precursor. Core-shell fillers which are useful additives to the precursor of the present invention comprise, for example, a rubber or a silicone polymer core which is bonded to a polymethylmethacrylate shell polymer. A preferred core/shell polymer is commercially available as Modifier 445006 from Wacker Chemie, Munich, Germany. The pressure-sensitive adhesive layer of the tape should be at least three times as thick as the diameter of the microspheres, preferably at least seven times.

The photopolymerizable precursor of the thermosettable adhesive according to both embodiments (A) and (B) may further comprise additives such as, for example, one or more inorganic fillers like finely divided iron oxide, titanium dioxide, calcium carbonate, carbon black or fumed silica. Especially preferred is hydrophilic silica which is commercially available, for example, from Degussa, Hanau, Germany, as Aerosil R 972, R 974 or R 976.

The photopolymerizable precursor of the thermosettable adhesive according to embodiments (A) and (B) may

further comprise one or more organic fillers such as, for example, finely divided polysaccharide fillers. Inorganic or organic fillers may be added to the precursor in order to improve its coating viscosity. Inorganic fillers and, in particular, fumed silica also tend to improve the mechanical properties and, in particular, the shear strength of the thermoset adhesive. The amount of inorganic and organic fillers preferably varies between 0 and 10% and more preferably between 0 and 5% by weight with respect to the mass of the pressure-sensitive adhesive.

While the precursor according to embodiment (B) mandatorily requires the addition of one or more polymers with a solubility parameter of between 10 and 12.5 in order to reduce the solubility of the hardener component (iv) in the photopolymerizable component (i) and the epoxy component (ii), the precursor according to embodiment (A) may optionally furthermore comprise polymer additives such as, for example, vinyl ester type polymers such as, for example, polyvinylacetate or polyvinylacetate copolymers or polyacetal type polymers such as, for example, polyvinylbutyral. Preferred are also phenoxy resins. The polymer materials listed illustrate the invention without limiting it and the precursor of embodiment (A) can comprise other essentially dead polymer additives.

The photopolymerizable component (i) of both embodiments (A) and (B) may furthermore comprise macromonomers which are copolymerizable with the respective component (i) such as, for example, the vinyl-terminated polymeric macromonomers described in US 3,786,116 or US 3,842,059.

In case of the precursor of embodiment (A) the amount of "dead" polymer additives and copolymerizable macromonomers preferably varies between 0 - 7.5% and more preferably between 0 - 5% by weight with respect to the mass of the pressure-sensitive adhesive. These additives are useful, for example, for improving adhesion of the thermally uncured and cured adhesive to various of substrates as well as controlling the viscosity of the precursor to aid coating and processing.

In case of the precursor of embodiment (B) the amount of copolymerizable macromonomers preferably varies between 0 - 5% and more preferably between 0-4% by weight with respect to the mass of the pressure-sensitive adhesive.

Other materials which can be blended with the precursor of the thermosettable adhesive of both embodiments (A) and (B) include tackifiers, plasticizers, coloring agents, reinforcing agents, fire retardants, thermally conductive agents, post-curing agents such as post-curing curatives and their accelerators, and the like.

Above and below, the mass percentages of components (i) - (iv) and, optionally, of other components and additives of embodiment (A) and (B) add up to 100% by weight for each precursor and thermosettable or thermoset adhesive, respectively.

<u>Preferred uses of the thermosettable adhesives of embodiments (A) and (B)</u>

The photopolymerized, thermosettable pressure-sensitive adhesive according to the present invention is preferably used in sheet-like or ribbon-like form such as, for example, as adhesive film or adhesive tape. Sheet-like adhesives can be used, for example, as adhesive sheet segments such as those formed by die-cutting.

Especially preferred are transfer films or tapes, comprising the photopolymerized, thermally-curable pressure-sensitive adhesive of the present invention attached to a removable adhesive-repellent backing or release liner. Transfer tapes can be obtained, for example, by coating the precursor according to the invention onto a flexible liner or carrier web such as a siliconized paper or siliconized polyester film, with subsequent photopolymerization in an inert, i.e., a substantially oxygen free atmosphere, e.g., a nitrogen atmosphere. A sufficiently inert atmosphere can be achieved by covering the layer of the precursor with a polymeric film liner such as a siliconized polyester film which is substantially transparent to ultraviolet radiation, and irradiating through that film in air as described in US 4,181,752 (Martens et al.).

The release liners are then removed prior to applying the resulting transfer tape of the thermosettable pressure-sensitive adhesive to a surface to be bonded.

The photopolymerized thermosettable pressure-sensitive adhesives of the present invention exhibit

- an onset temperature of the epoxy curing reaction of below 100°C, and
- advantageous adhesion to various surfaces and, in particular, to low energy surfaces such as plastic surfaces prior to and after thermal curing.

The low onset temperature of the epoxy curing reaction allows for low curing temperatures of below, for example, 100°C which is compatible with most plastic substrates when using oven curing. The thermosettable pressure-sensitive adhesive of the present invention is therefore especially useful for bonding a plastic substrate to other substrates such as metal, glass, ceramic, wood and plastics.

The pressure-sensitive adhesive of the present invention is particularly useful for bonding two plastic surfaces. The resulting assembly is characterized by advantageous mechanical properties and exhibits an overlap shear strength of at least 3 MPa, more preferably of at least 4 MPa and, especially preferably, of 5 MPa or more. Assemblies comprising

two plastic surfaces which are bonded with a thermoset adhesive the precursor of which comprises a blend of an acrylate-based pressure-sensitive adhesive and one or more thermosettable epoxy resins and/or monomers and is cured at a temperature above the onset temperature of the epoxy curing reaction of below 100°C to give an overlap shear strength of the assembly of at least 3 MPa, are new and they are subject matter of the present invention.

Curing at relatively low temperatures of not more than 100°C typically requires curing times of between 30 to 120 minutes or less. The curing times can be decreased by increasing the curing temperature and it was found that higher curing temperatures can be used to adhere, for example, metal bars or metal buttons to plastic substrates using, for example, the hand-held device described in EP-A-0 823 312.

It was furthermore found that the photopolymerized thermosettable adhesive of the present invention exhibits advantageous adhesion to various surfaces such as metal, glass or ceramics prior to and after thermal curing and can be used for preparing assemblies such as, for example, metal-metal, glass-metal, glass-glass, metal-ceramic and so on. Many of these assemblies can be prepared at higher curing temperatures.

The invention is further illustrated by the following Examples. Prior to that some test methods used to characterize the thermosettable and thermoset pressure-sensitive adhesive, respectively, according to the invention will be described. In the examples, percentages given are percents by weight and refer to the mass of the photopolymerizable precursor of the thermosettable adhesive. PPh means parts per hundred resin and refers to the mass of component (i).

Test methods

Overlap shear strength test

Dynamic overlap shear tests were performed on assemblies comprising the sequence Al coupon/adhesive/Al coupon or plastic coupon/adhesive/plastic coupon, respectively, using a modified version of ISO 4587 or DIN 53283, respectively. The adhesive layers used are specified in the Examples and comprise thermally-cured or thermoset adhesive layers. The test method used deviated from the standard test methods specified above in that the crosshead speed was 5 mm/min. The tests were repeated three times for each sample and an average value was recorded in MPa.

Assemblies tested:

1. Al/adhesive/Al

Al coupons (100 m x 25 mm x 2 mm) were subjected to light abrasion treatment with a Scotchbrite™ scrubbing pad (available from 3M Company) followed by soap/water and finally cleaned with isopropyl alcohol.

One of the two protective liners was removed from the adhesive layer and the adhesive surface was applied by hand to the cleaned surface of one of the coupons. Then the other liner was removed and the second adhesive surface placed against the cleaned surface of the second coupon in the configuration described in above methods. The adhesive layer was aligned with the longer side perpendicular to the direction of the applied force during the overlap shear test and it was always placed so that it was flush with the end of the bonded coupon.

The assembly obtained was passed through a laboratory scale laminator available from Sallmetal (Raalte, The Netherlands), using a pressure of 2 kg and a speed of 300 mm/min to remove air bubbles and ensure a uniform contact. The assemblies were passed through the laminator two times.

The assemblies were subjected to thermal curing in a forced air oven at 85°C for 45 minutes. Prior to testing, the assemblies were conditioned in a constant temperature room (23°C, 55% relative humidity) for at least 12 hours.

2. Plastic/adhesive/plastic

Two coupons (75 mm x 15 mm x 10 mm) of the same plastic material were cleaned with isopropyl alcohol and dried. The assembly was obtained as is described above for the Al/adhesive/Al assemblies.

The following plastic materials were used:

- polycarbonate (PC), available as Lexan™, clear, from General Electric Plastic
- polymethylmethacrylate (PMMA), available as Plexiglas™ (clear) from Rohm & Haas, Darmstadt, Germany
- acrylonitrile butadiene styrene (ABS), available as Royalite™ (general purpose) from Uniroyal, USA
- plasticized polyvinylchloride (PVC), available from BGS Kunststoff GmbH, Duesseldorf
- polyamide (PA), available from BGS Kunststoff GmbH
- polyethylene (PE)

- polyethyleneterphthalate (PET)

Dynamic shear strength test

An adhesive bond is prepared by adhering a bracket bearing a flat plate having the dimensions 1 mm x 16 mm x 23 mm to 5 mm thick test substrate having the dimensions 30 mm x 80 mm using an adhesive layer 500 µm thick and having the same dimensions as the flat plate of the bracket (16 mm x 23 mm). The test bracket is made of mild steel and is available commercially as A-2516 from R. A. Labone Company (Ilkeston, UK). The bracket is scrubbed with a scouring pad and cleaned with MEK before the adhesive bond is formed.

The adhesive bond is then thermally-cured using a Double Fast-Curing Device for Clips, commercially available as Model 1856-95 from ARI di Villa Aurelio e Perino s. n. c., 20065 Inzago, Italy. The assembly comprising the test bracket-adhesive-substrate is placed on the curing device so that the back of the flat plate of the metal bracket is in contact with the heated metal blocks of the curing device.

The resulting bond is tested using an electronic tensile tester having a 5 kN load cell. The test substrate is grasped in one of the jaws of the tensile tester and the second jaw is aligned so that it can be used to exert force against the steel test bracket in a manner such that shearing forces are applied to the adhesive bond.

The jaws of the tensile tester are then moved together at a rate of 5 mm/min until the steel bracket is sheared away from the test substrate.

The force required to break the adhesive bond was recorded in N and normalized using the cross-section dimensions of the adhesive bond, resulting in test value expressed in $N/mm^2$.

The strength of the bond was measured three times by testing three separately prepared assemblies and then averaging the results.

Cleavage strength test

An adhesive bond was prepared by adhering an aluminum bracket to a 6 mm thick sheet of rolled glass. The flat base of the aluminum bracket was circular and had a diameter of 20 mm. The aluminum bracket was adhered to the glass substrate using a circular section of adhesive having a thickness of 0.5 mm and a diameter of 20 mm.

The adhesive layer of the assembly thus prepared was thermally cured using a hand-held device such as that described in EP-A-0 823 312.

The strength of the adhesive bond was determined by applying cleavage forces to the bond by, first, mechanically engaging one end of a lever arm with the aluminum bracket, and, then, in a 90° fashion while holding the glass substrate stationary, exerting force on the lever arm at a distance of 50 mm from the adhesive bond. Force was applied using an electronic tensile tester having a 5 kN load cell by moving the jaws apart at a rate of 2.5 mm/min until bond failure resulted. The force required to break the bond was recorded in N.

90° peel adhesion test

90° Peel adhesive was determined using PSTC-14, a procedure specified in "Test Methods for Pressure Sensitive Adhesive Tapes," 8th edition, available from the Pressure-Sensitive Adhesive Tape Council, 1800 Pickwick Ave., Glenview, IL 600025-1377, U.S.A.

Layers of the respective adhesives described in the Examples which were protected by two liners, were cut into strips with a width of 12.7 mm. One of the two liners was removed from the adhesive layer and a strip of an aluminum foil (0.135 mm thick, width of 16 mm) was applied to the exposed adhesive by hand pressure.
Then the second liner was removed and the exposed adhesive applied to the respective substrate. The assembly thus prepared was passed between the rubber-coated rolls of a laboratory scale laminator (Sallmetal, Raalte, The Netherlands) at a speed of 300 mm/min and a pressure of 2 kg. The assemblies were passed through the laminator twice.

The construction obtained was allowed to rest in a constant temperature room (23°C, 55% relative humidity) for 30 minutes before testing. The adhesives tested were not thermally cured before the peel adhesion test.

Onset temperature of the epoxy curing reaction

The onset temperature of the epoxy curing reaction is measured by heating an 8 mg sample of the photopolymerized, thermally-uncured pressure-sensitive adhesive from -20 to 250°C at a rate of 20°C/min. The measurements were performed using a differential scanning calorimeter Model 7 manufactured by Perkin-Elmer. The onset temperature was calculated by the computer software provided as an integral part of the instrument.

Materials used in the Examples

Ethylenically unsaturated monomers

1. 2-Phenoxy ethyl acrylate (2-PhEA), available from Osaka Chemicals, Japan.
2. Isobornylacrylate (IBA), available from Osaka Chemicals, Japan.
3. N-Vinyl caprolactam (NVC), available from BASF, Germany
4. Butyl acrylate (BA), available from Aldrich, U.S.A.

Thermosetting epoxy resins

1. DER 331, digylcidyl ether bisphenol A tape resin (aromatic), epoxy equivalent weight 180, available from Dow Chemical, Midland, MI, USA
2. DEN 431, epoxy equivalent weight 175, available from Dow Chemical, Midland, MI, USA
3. DEN 438, epoxy equivalent weight 175, available from Dow Chemical, Midland, MI, USA
4. ERL 4221, cycloaliphatic 3,4 epoxy (specifically 3,4-epoxycyclohexylmethyl-3,4-epoxy-cyclohexane-carboxylate), epoxy equivalent weight 137, available from Union Carbide.
5. EPON 828, diglycidic ether of bisphenol-A, available from Shell Chemical
6. EPON 1001, diglycidic ether of bisphenol-A, available from Shell Chemical

Hardeners

1. A2337XS, Ancamine (TM) modified aliphatic amine, available from Air Products (Manchester, UK)
2. A2014FG, Ancamine (TM) modified aliphatic amine, available from Air Products (Manchester, UK).
3. HT 939, available from Ciba Geigy, Switzerland

Photoinitiators

1. 2,2 Dimethoxy-2-phenylacetophenone, available as Irgacure 651 from Ciba Geigy (I 651)
2. 2,2 Dimethoxy-2-phenylacetophenone, available as KB-1 from Sartomer, Exton, PA (KB-1)

Crosslinkers

1. 1,6-Hexanediol diacrylate, available from BASF (HDDA)

Polymers

1. Polyvinyl acetate, available as Vinnapas UW1 from Wacker Chemie, Burghausen, Germany (UW1)
2. Levapren KA 8479, ethylene vinyl acetate copolymer from Bayer, Leverkusen, Germany; 80% vinyl acetate, 20% ethylene (KA 8479)
3. Levapren 700 HV, ethylene vinyl acetate copolymer from Bayer, Leverkusen, Germany; 70% vinyl acetate, 30% ethylene (700 HV)
4. Core shell polymer, available as EXL 2691 from Rohm & Haas, Philadelphia, PA, USA (EXL 2691)

Fillers

1. Hydrophobic fumed silica, available as Aerosil R972 from Degussa, Hanau, Germany (R 972)
2. Hollow glass microspheres, available from 3M Company, St. Paul, U.S.A. as C15/250 (average diameter 20-120

μm) (GB)

EXAMPLES

Example 1

Isobornyl acrylate (23% by weight) and phenoxy ethyl acrylate (15% by weight) were combined with 0.04 pph Irgacure 651 photoinitiator and stirred until the photoinitiator was dissolved. This mixture was then purged with nitrogen and partially polymerized using UV radiation so that about 4-10% polymer was present, as described in US 4,181,752, thus forming a partially polymerized, coatable syrup. The polymerization was stopped by removing the light source.

An additional portion (0.16 pph) of Irgacure 651 photoinitiator was then added, as well as 0.1 pph 1,6-hexanediol diacrylate (HDDA) crosslinker.

Then 42% by weight of DER 331 and 20% by weight of A2337XS were added and the mixture was mixed mechanically for 36 hours or until homogeneous.

The viscous mixture was then coated onto a 40 micron transparent silicone-coated polyester liner to a thickness of 500 microns using a knife coater and coated with a second transparent silicone-coated polyester liner. The acrylic monomers were then radically photopolymerized between the two transparent liners using UV light as described in US 4,181,752. The total UV energy applied was 2.7 $mW/cm^2$.

Onset temperature of the epoxy curing reaction, 90° peel adhesion of the thermally-uncured adhesive and overlap shear strength of the thermally-cured adhesive were measured as described above. The onset temperature was 70°C. The other results are summarized in Table 3.

Examples 2 - 15 and Comparative Examples 1 - 4

Adhesive layers were prepared according to the method of Example 1, varying the composition as indicated in Table 2. IBA is isobornylacrylate, 2-PhEA is phenoxyethyl acrylate and epoxy (type) and hardener (type), respectively, denote the epoxy resin and the hardener compound, respectively, according to the list "Materials used in the Examples" which was given above.

Onset temperature of the epoxy curing reaction, 90° peel adhesion of the thermally-uncured adhesive and overlap shear strength of the thermally-cured adhesive were measured as described above. The onset temperatures measured in Examples 2-15 were 69-70 °C. The other results are summarized in Table 3.

Comparative Example 5

A commercially available high performance acrylic bonding transfer tape (VHB acrylic adhesive tape 4945, available from Minnesota Mining and Manufacturing Co., St. Paul, Minnesota, USA) was subjected to the 90° peel adhesion test and the overlap shear strength test as described under Test Methods above, with the exception that the assembly used for the measurement of overlap was not subjected to thermal curing before overlap shear strength was measured. The results obtained are given in Table 3.

3M Tape 4945 is a non-thermosettable pressure-sensitive adhesive tape and is included as a comparative example to show bond strength and performance of a state-of-the art high performance pressure-sensitive tape which is not thermally curable.

Comparative Example 6

A commercially available thermally-curable epoxy/acrylate pressure-sensitive adhesive transfer tape (3M 9245 SBT available from Minnesota Mining and Manufacturing Co. St. Paul, Minnesota, USA) was subjected to the 90° peel adhesion test and the overlap shear strength test as described under the Test Methods above with the exception that the assembly used for the measurement of overlap shear strength was thermally cured at a temperature of 170°C for 30 minutes.

The overall solubility parameter of the photopolymerizable component (i) of Tape 9245 is about 10.5, and 9245 contains more than 10% by weight with respect to the photopolymerizable component of monomeric compounds with a solubility parameter of more than 11.5 The onset temperature of the epoxy curing reaction of Tape 9245 is about 135°C.

Examples 16-21

Acrylic monomers as listed in Table 4 were combined with 0.2 pph Irgacure 651 photoinitiator, 0.1 pph 1,6-hexanediol diacrylate (HDDA) and stirred until the photoinitiator was dissolved. Epoxy resins, hardener compounds, fillers and polymers were added sequentially in the amounts given in Table 4, and stirred mechanically until the mixture was homogeneous.

No prepolymerization to a syrup was necessary in this case, as a coatable viscosity was inherently present.

Onset temperature of the epoxy curing reaction, 90° peel adhesion and overlap shear strength were measured for the adhesives of Examples 16-20 as described above. The onset temperatures of Examples 16-21 were 70-73°C. The other results are summarized in Table 5.

A layer of the photopolymerized, thermosettable adhesive of Example 21 with a thickness of 500 µm was applied to a steel mounting bracket having a flat plate (dimensions of 1 x 16 x 23 mm) and adhered to polycarbonate or polymethacrylate substrates, respectively (dimension 80 x 30 x 5 µm). The backside of the steel bracket was then contacted with a heated metal plate as described under the test method "Dynamic Shear Strength Test" and held at an elevated temperature which was varied as described in Table 6. Table 6 also gives the times for which metal bracket was contacted with the heated plate, as well as the respective plastic substrate.

The assemblies obtained were subjected to the dynamic shear test described above, and the results are given in Table 6.

A layer of the photopolymerized, thermosettable adhesive of Example 21 with a thickness of 500 µm was applied to an aluminum mounting bracket having a round 20 mm diameter base plate) and adhered to a 6 mm thick sheet of float glass. The face of the base plate of the aluminum bracket was then contacted with the hand-held device described in copending European patent application no. 96 112 715.6 to thermally cure the adhesive layer. The contact time and the temperature of the contact means of the hand-held device are varied as specified in Table 7.

The assemblies obtained were subjected to the cleavage strength test described above, and the results are given in Table 7.

<u>Examples 22-24</u>

Acrylic monomers as listed in Table 8 were combined with 0.04 pph of Irgacure 651 photoinitiator. The mixture was purged with nitrogen for 30 minutes and then exposed to low intensity ultraviolet radiation as described in Example 1 until a low viscosity syrup was obtained. To this syrup were added in the amounts listed in Table 8: N-vinyl caprolactam (NVC), epoxy resin, 0.1 pph crosslinker HDDA, 0.16 pph additional photoinitiator Irgacure 651, epoxy hardener. The mixture was stirred until homogeneous.

Onset temperature of the epoxy curing reaction, 90° peel adhesion of the thermally-uncured adhesive and dynamic shear strength of the thermally-cured adhesive was measured as described above. The results are summarized in Table 9.

<u>Examples 25-31 and Comparative Example 9</u>

Butyl acrylate and N-vinyl caprolactam in an amount as specified in Table 10 were combined with 0.2 or 0.3 pph, respectively, of photoinitiator KB-1, 0.047 pph of HDDA (crosslinker) and polymers of the type and in the amount given in Table 10 and stirred until homogeneous. Epoxy resins, hardeners and fillers were added sequentially in the amounts given in Table 10, and stirred mechanically until homogeneous.

No prepolymerization to a syrup was necessary in this case, as a coatable viscosity was inherently present. The photopolymerizable component (i) of Comparative Example 7 has a solubility parameter of 9.93.

Onset temperature of the epoxy curing reaction, 90° peel adhesion of the thermally uncured adhesive and overlap shear strength of the thermally-cured adhesive were measured as described above. The onset temperatures measured in Examples 25-31 and Comparative Example 9 were about 89 °C. The other results are summarized in Table 11.

TABLE I

| FEDORS' SOLUBILITY PARAMETERS OF ACRYLATE MONOMERS | |
|---|---|
| **Monomer** | **Solubility Parameter $(cal/cm^3)^{0.5}$** |
| Octadecyl acrylate (ODA) | 8.99 |
| Lauryl acrylate (LA) | 9.15 |
| Iso-octyl acrylate (IOA) | 9.22 |
| 2-ethylhexyl acrylate (2-EHA) | 9.22 |

TABLE I (continued)

| FEDORS' SOLUBILITY PARAMETERS OF ACRYLATE MONOMERS | |
|---|---|
| **Monomer** | **Solubility Parameter (cal/ $cm^3)^{0.5}$** |
| Tert-Butyl acrylate (TBA) | 9.36 |
| Iso-Butyl acrylate (PHA) | 9.57 |
| Butyl acrylate (BA) | 9.77 |
| Propyl acrylate (PA) | 9.95 |
| Ethyl acrylate (EA) | 10.20 |
| | |
| 3,3,5 trimethylcyclohexyl acrylate (TMCA) | 9.35 |
| Iso-bornyl acrylate (IBA) | 9.71 |
| Cyclohexyl acrylate | 10.16 |
| N-octyl acrylamide (NOA) | 10.33 |
| Tetrahydrofurfuryl acrylate (HFA) | 10.53 |
| Methyl acrylate (MA) | 10.56 |
| 2-Phenoxyethylacrylate (2-PhEA) | 11.03 |
| Phenyl acrylate (PHA) | 11.19 |
| Glycidyl acrylate (GA) | 11.32 |
| N-vinylcaprolactam (NVC) | 12.10 |
| N,N-Dimethylacrylamide (DMA) | 12.32 |
| Butoxy acrylate (BOA) | 12.99 |
| N-vinyl-2-pyrrolidone (NVP) | 13.38 |
| Propoxy acrylate (POA) | 13.62 |
| Acrylic Acid (AA) | 14.04 |
| | |
| Methylmethacrylate (MMA) | 9.93 |
| Ethylmethacrylate (EMA) | 9.72 |
| Propylmethacrylate (PMA) | 9.57 |
| | |
| Vinyl Acetate | 10.56 |
| Styrene | 11.87 |

TABLE 2

| Example | IBA [%] | 2-PhEA [%] | Epoxy resin [%] (type) | Hardener compound [%] (type) | I651 *) [pph] |
|---|---|---|---|---|---|
| 1 | 22.9 | 15.3 | 42.0 (1) | 19.8 (1) | 0.2 |
| 2 | 11.4 | 26.5 | 41.7 (2) | 20.4 (1) | 0.2 |
| 3 | 7.6 | 30.3 | 41.7 (3) | 20.4 (1) | 0.2 |

*) The mass of the photoinitiator I 651 is disregarded when calculating the mass percentages [%] of the other compounds.

TABLE 2 (continued)

| Example | IBA [%] | 2-PhEA [%] | Epoxy resin [%] (type) | Hardener compound [%] (type) | I651 *) [pph] |
|---|---|---|---|---|---|
| 4 | 24.8 | 16.6 | 45.4 (1) | 13.2 (2) | 0.2 |
| 5 | 12.3 | 28.8 | 45.3 (2) | 13.6 (2) | 0.2 |
| 6 | 8.2 | 32.9 | 45.3 (3) | 13.6 (2) | 0.2 |
| 7 | 19.1 | 19.1 | 42.0 (1) | 19.8 (1) | 0.2 |
| 8 | 25.9 | 26.0 | 32.6 (1) | 15.5 (1) | 0.2 |
| 9 | 26.7 | 11.5 | 42.0 (1) | 19.8 (1) | 0.2 |
| 10 | 30.7 | 13.2 | 38.1 (1) | 18.0 (1) | 0.2 |
| 11 | 36.3 | 15.6 | 32.6 (1) | 15.5 (1) | 0.2 |
| 12 | 31.1 | 17.6 | 34.7 (1) | 16.6 (1) | 0.2 |
| 13 | 16.6 | 33.7 | 33.6 (1) | 16.1 (1) | 0.2 |
| 14 | 16.1 | 24.3 | 40.3 (1) | 19.3 (1) | 0.2 |
| 15 | 24.3 | 16.1 | 40.3 (1) | 19.3 (1) | 0.2 |
| C1 | 30.5 | 5.4 | 39.4 (4) | 24.7 (1) | 0.2 |
| C2 | 33.7 | 6.0 | 43.7 (4) | 16.6 (2) | 0.2 |
| C3 | 34.4 | 3.8 | 42.0 (1) | 19.8 (1) | 0.2 |
| C4 | 46.7 | 5.2 | 32.6 (1) | 15.5 (1) | 0.2 |

*) The mass of the photoinitiator I 651 is disregarded when calculating the mass percentages [%] of the other compounds.

TABLE 3

| Ex | Overlap Shear ($N/mm^2$) | | | | 90° Peel (N/1.27 cm) | | | | |
|---|---|---|---|---|---|---|---|---|---|
| | Al | PC | pMMA | PVC | PC | pMMA | PVC | PE | Al |
| 1 | 7.4 | | | | | | | | |
| 2 | 3.3 | | | | | | | | |
| 3 | 0.4 | | | | | | | | |
| 4 | 4.5 | | | | | | | | |
| 5 | 0.2 | | | | | | | | |
| 6 | 1.4 | | | | | | | | |
| 7 | 6.2 | 4.5 | 4.3 | 4.4 | 12 | 14 | 9 | 7 | |
| 8 | 4.5 | 2.4 | 2.3 | 2.1 | 19 | 16 | 3 | 2 | |
| 9 | 3.6 | 3.0 | 2.5 | 2.5 | 13 | 14 | 7 | 7 | |
| 10 | 3.4 | 2.5 | 2.8 | 2.1 | 14 | 14 | 7 | 7 | |
| 11 | 3.3 | 2.5 | 2.2 | 1.7 | 14 | 16 | 5 | 5 | |
| 12 | 8.5 | 2.6 | | | 7 | | | | 10 |
| 13 | 2.8 | 1.7 | | | 25 | | | | 14 |
| 14 | 3.9 | 2.8 | | | 14 | | | | 13 |
| 15 | 7.6 | 4.4 | | | 7 | | | | 13 |
| C1 | 0.02 | | | | | | | | |

TABLE 3 (continued)

| Ex | Overlap Shear (N/mm$^2$) | | | | 90° Peel (N/1.27 cm) | | | | |
|---|---|---|---|---|---|---|---|---|---|
| | Al | PC | pMMA | PVC | PC | pMMA | PVC | PE | Al |
| C2 | 0.02 | | | | | | | | |
| C3 | 2.3 | 1.9 | 1.7 | 1.2 | 15 | 14 | 6 | 5 | |
| C4 | 1.3 | 1.3 | 1.1 | 1.0 | 15 | 15 | 6 | 5 | |
| C5 | 1 | 1 | 1 | 1 | 23 | 24 | 8 | 4 | |
| C6 | 11 | 1.3 | 1.6 | **) | 28 | 24 | 7 | 3 | |

**) No measurement possible. PVC melts at the required curing temperature (160°C)

TABLE 4

| Ex | IBA [%] | 2- PheEA [%] | Epoxy (type) [%] | Hardener (type) [%] | R972 [%] | Polymer (type) [%] | I 651 *) [pph] | HDDA *) [pph] |
|---|---|---|---|---|---|---|---|---|
| 16 | 18.5 | 24.6 | 37.1(1) | 17.7(1) | 2.1 | 0 | 0.2 | 0.1 |
| 17 | 17.4 | 23.2 | 34.8(1) | 16.6(1) | 4.0 | 4.0(1) | 0.2 | 0.1 |
| 18 | 18.1 | 24.1 | 36.3(1) | 17.3(1) | 2.1 | 2.1(1) | 0.2 | 0.1 |
| 19 | 18.5 | 24.6 | 37.1(1) | 17.6(1) | 0 | 2.2(1) | 0.2 | 0.1 |
| 20 | 16.3 | 21.8 | 34.2(1) | 16.3(1) | 3.8 | 7.6(4) | 0.2 | 0.1 |
| 21 | 23.7 | 18.0 | 35.7(1) | 17.0(1) | 4.1 | 1.5(1) | 0.2 | 0.1 |

*) The masses of the photoinitiator and the crosslinker are disregarded when calculating the mass percentages [%] of the other compounds.

TABLE 5

| Ex | Overlap Shear (N/mm$^2$) | | | | | 90° Peel (N/1.27 cm) | | | | |
|---|---|---|---|---|---|---|---|---|---|---|
| | Al | PC | pMMA | PVC | ABS | PC | pMMA | PVC | PE | Al |
| 16 | 8.8* | 3.8 | 6.5 | 5.3* | 6.2 | | | | | 14 |
| 17 | 5.9* | 4.4 | 6.9 | 4.3* | 6.3 | | | | | 16 |
| 18 | 8.0 | 4.2 | 6.1 | 4.7* | 6.0 | | | | | 18 |
| 19 | 7.9 | 3.6 | 4.6 | 4.0* | 4.6 | | | | | 13 |
| 20 | 4.7* | 3.4 | 4.1* | 4.3* | 5.8* | 13 | | | | 19 |

* adhesive failure or mixed adhesive/cohesive failure

TABLE 6

| Sample | Plastic Substrate | Contact Time [S] | Temp. of heated bar [°C] | Dynamic shear [N/mm$^2$] |
|---|---|---|---|---|
| 1 | PC | 30 | 250 | 1.31 1 |
| 2 | PC | 30 | 225 | 3.30 |
| 3 | PC | 30 | 200 | 3.88 |
| 4 | PC | 30 | 175 | 3.18 |
| 5 | PC | 30 | 150 | 2.01 |
| 6 | PC | 70 | 150 | 5.03 |
| 7 | PMMA | 30 | 250 | 3.41 |

TABLE 6 (continued)

| Sample | Plastic Substrate | Contact Time [S] | Temp. of heated bar [°C] | Dynamic shear [N/mm$^2$] |
|---|---|---|---|---|
| 8 | PMMA | 30 | 225 | 4.52 |
| 9 | PMMA | 30 | 200 | 4.60 |
| 10 | PMMA | 30 | 175 | 2.77 |
| 11 | PMMA | 30 | 150 | 1.94 |
| 12 | PMMA | 70 | 150 | 5.56 |
| 13 | PMMA | 60 | 250 | 2.56 |
| 14 | PMMA | 60 | 250 | 4.92 |

PC = polycarbonate
PMMA = polymethylmethacrylate

TABLE 7

| Sample | Temp of contact mans of hand-held device [°C] | Contact time [seconds] | Max. cleavage strength [N] |
|---|---|---|---|
| 1 | 230 | 60 | 238 |
| 2 | 230 | 35 | 137 |
| 3 | 186 | 57 | 130 |
| 4 | 273 | 13 | 79 |
| 5 | 230 | 35 | 210 |
| 6 | 186 | 13 | 37 |
| 7 | 230 | 10 | 43 |
| 8 | 180 | 35 | 45 |
| 9 | 273 | 57 | 117 |
| 10 | 280 | 35 | 154 |
| 11 | 230 | 35 | 204 |
| 12 | 186 | 100 | 292 |
| 13 | 230 | 100 | 307 |
| 14 | 186 | 100 | 229 |
| 15 | 230 | 150 | 261 |
| 16 | 273 | 150 | 127 |

TABLE 8

| Ex | IBA, % | 2- PhEA, % | NVC, % | Epoxy resin, % (type) | Hardener compound, % (type) |
|---|---|---|---|---|---|
| 22 | 16 | 23 | 3 | 39 | 19 |
| 23 | 16 | 23 | 2 | 40 | 19 |
| 24 | 16 | 24 | 1 | 40 | 19 |

TABLE 9

| Example | 90° Peel (N / 1.27 cm) | | Dynamic shear (N / mm$^2$) | | |
|---|---|---|---|---|---|
| | PMMA | Al | PMMA | PC | Al |
| 22 | 16.2 | 12.9 | 4.47 | 3.81 | 5.31 |
| 23 | 14.6 | 12.3 | 3.09 | 1.89 | 3.96 |
| 24 | 12.4 | 11.0 | 3.24 | 1.63 | 3.90 |

TABLE 10

| Ex | BA [%] | NVC [%] | Epoxy resin (type) [%] | Hardener (type) [%] | Polymer (type) [%] | Filler (type) [%] | KB-1 *) [pph] | HDDA *) [pph] |
|---|---|---|---|---|---|---|---|---|
| 25 | 32.2 | 9 | 23.2 (5)<br>12.9 (6) | 12.4 (3) | 10.3 (1) | | 0.2 | 0.047 |
| 26 | 31.8 | 8.9 | 22.8 (5)<br>12.7 (6) | 13.7 (1) | 10.1 (2) | | 0.3 | 0.047 |
| 27 | 31.8 | 8.9 | 22.8 (5)<br>12.7 (6) | 13.7 (1) | 10.1 (3) | | 0.3 | 0.047 |
| 28 | 30.8 | 8.6 | 22.2 (5)<br>12.3 (6) | 13.3 (1) | 9.8 (1) | 2.5 (1)<br>0.5 (2) | 0.3 | 0.047 |
| 29 | 33.1 | 8.8 | 19.8 (5)<br>19.8 (6) | 10.9 (1) | 4.6 (1) | 2.3 (1)<br>0.7 (2) | 0.3 | 0.047 |
| 30 | 28.9 | 8.5 | 26.4 (5)<br>8.5 (6) | 12 (1) | 12.5 (1) | 2.5 (1)<br>0.7 (2) | 0.3 | 0.047 |
| 31 | 35.6 | 10.5 | 17.8 (5)<br>17.8 (6) | 9.9 (1) | 5.1 (1) | 2.5 (1)<br>0.8 (2) | 0.3 | 0.047 |
| C7 | 35.6 | 2.7 | 17.9 (5)<br>17.9(6) | 9.9 (1) | 12.5 (1) | 2.5 (1)<br>0.8 (2) | 0.3 | 0.047 |

*) The masses of the photoinitiator and the crosslinker are disregarded when calculating the mass percentages [%] of the components with respect to the mass of the adhesive

TABLE 11

| Ex | Overlap Shear (N/mm$^2$) | | | | 90° Peel (N/1.27 cm) | | |
|---|---|---|---|---|---|---|---|
| | Al | PC | pMM A | ABS | PC | pMM A | ABS |
| 25 | 3.4* | 3.2 | 3.1 | 3.2* | 38.5 | 37.1 | 27.3 |
| 26 | 1.8* | 2.9 | 3.4 | 3.5 | 25.2 | 22.5 | 18.2 |
| 27 | 2.6 | 2.5 | 2.8 | 2.9 | 24.7 | 22.3 | 19 |
| 28 | 3.6* | 3 | 4 | 3.1* | 31 | 43 | 11.4 |
| 29 | 2.9* | 3.7 | 3.6 | 3.7 | 26.1 | 38.4 | 18.2 |
| 30 | 3.5* | 3.1 | 4 | 3.2* | 25.5 | 40.9 | 13.5 |
| 31 | 3.7* | 4 | 4.2 | 4 | 24.7 | 35.2 | 11.3 |
| C7 | 1.9 | 1.8 | 2* | 1.9 | 1.1 | 1.5 | 1.1 |

*) adhesive failure or mixed adhesive/cohesive failure

## Claims

**1.** Photopolymerizable precursor of a pressure-sensitive thermosettable adhesive comprising

(i) from about 30% to about 80% by weight with respect to the mass of the precursor of a photopolymerizable component, comprising a monomeric or prepolymeric syrup, said component exhibiting an overall solubility parameter of between 10 and 11 and comprising (A) at least 30% by weight with respect to the mass of the photopolymerizable component (i) of one or more ethylenically unsaturated monomers with a solubility parameter of between 10 and 11.5 and less than 10% by weight with respect to the mass of component (i) of one or more ethylenically unsaturated monomers with a solubility parameter of more than 11.5, or (B) at least 50% by weight with respect to the mass of the photopolymerizable component (i) of one or more ethylenically unsaturated monomers with a solubility parameter of between 9.5 and 11.5 and 10-30% by weight with respect to the mass of the photopolymerizable component (i) of one or more ethylenically unsaturated monomers with a solubility parameter of between 11.5 and 12.5 provided that in case (B) the precursor comprises between 3-15% by weight with respect to the mass of the precursor of one or more polymers with a solubility parameter of 10-12.5,

(ii) from about 20 to about 70% by weight with respect to the mass of the precursor of one or more epoxy resins and/or monomers,

(iii) an effective amount of one or more photoinitiators, and

(iv) an effective amount of one or more nucleophilic latent hardeners for the epoxy resins and/or epoxy-containing monomers which hardeners are selected to provide an onset temperature of the epoxy curing reaction of between 40-100°C when subjecting the adhesive to a DSC scan at a rate of 20°C/min,

wherein the solubility parameters are calculated in each case according to the Fedors method and are reported in $(cal/cm^3)^{0.5}$ and wherein the mass percentages of components (i) - (iv) and, optionally, of other components and additives add up to 100 % by weight.

**2.** Precursor according to claim 1, wherein the photocopolymerizable component (i) of embodiment (A) additionally comprises at least 15% with respect to the mass of component (i) of one or copolymerizable ethylenically unsaturated monomers with a solubility parameter of between 9.5 and 10, and wherein the polymers with a solubility parameter of between 10 and 12.5 of the precursor of embodiment (B) have a molecular weight Mw of about 50,000 - 500,000 g/mol.

**3.** Precursor according to any of claims 1 or 2 wherein one or more of the hardener compounds are selected from a group of compounds according to formula II

$$R - X_i \qquad \text{II}$$

wherein R is a mono- or multivalent organic residue, X; is independently from one another a linear or branched alkyl group with at least 8 C atoms wherein at least one of the -CH2- groups is replaced with a -NH-group and/or which exhibits a terminal N- containing group which contains at least one active H atom, and i is an integer from 1 to 4.

**4.** Precursor according to any of claims 1 - 3 wherein one or more of the ethylenically unsaturated monomers are selected from a group comprising (meth)acrylic esters of non-tertiary alcohols and N-atom containing ethylenically unsaturated compounds.

**5.** Thermosettable pressure-sensitive adhesive which is obtainable by photopolymerization of the precursor according to claims 1-4.

**6.** Thermosettable pressure-sensitive adhesive according to claim 5 which exhibits a percentage of remaining reaction of at least 90% after 8 weeks of storage.

7. Thermoset adhesive which is obtainable by thermally curing the thermosettable pressure-sensitive adhesive according to claims 5 or 6.

8. A method for bonding a plastic surface to another surface comprising

(i) sandwiching a layer of a pressure-sensitive thermosettable adhesive according to any of claims 5 or 6 between the two surfaces, and

(ii) heating the assembly to a temperature above the onset temperature of the epoxy curing reaction.

9. Assembly comprising two plastic surfaces which are bonded with a thermoset adhesive obtainable by curing a precursor according to any of claims 1 - 4 at a temperature above the onset temperature ofthe epoxy curing reaction of below 100 °C to give an overlap shear strength of the assembly of at least 3 MPa.

10. Assembly comprising at least one plastic surface which is obtained by

(i) sandwiching a layer of a pressure-sensitive thermosettable adhesive according to any of claims 5 or 6 between the two surfaces, and

(ii) heating the assembly at a temperature above the onset temperature of the epoxy curing reaction.

**Revendications**

1. Précurseur photopolymérisable d'un adhésif thermodurcissable sensible à la pression comprenant

(i) d'environ 30% à environ 80% en poids, par rapport à la masse du précurseur, d'un constituant photopolymérisable, comprenant un sirop monomère ou prépolymère, ledit constituant présentant un paramètre de solubilité globale compris entre 10 et 11 et comprenant (A) au moins 30% en poids, par rapport à la masse du constituant photopolymérisable (i), d'un ou plusieurs monomères à insaturation éthylénique ayant un paramètre de solubilité compris entre 10 et 11,5 et moins de 10% en poids, par rapport à la masse du constituant (i), d'un ou plusieurs monomères à insaturation éthylénique ayant un paramètre de solubilité supérieur à 11,5, ou (B) au moins 50% en poids, par rapport à la masse du constituant photopolymérisable (i), d'un ou plusieurs monomères à insaturation éthylénique ayant un paramètre de solubilité compris entre 9,5 et 11,5 et 10-30%, par rapport à la masse du constituant photopolymérisable (i), d'un ou plusieurs monomères à insaturation éthylénique ayant un paramètre de solubilité compris entre 11,5 et 12,5, à condition que, dans le cas (B), le précurseur comprenne entre 3 et 15% en poids, par rapport à la masse du précurseur, d'un ou plusieurs polymères ayant un paramètre de solubilité de 10-12,5,
(ii) d'environ 20 à environ 70% en poids, par rapport à la masse du précurseur, d'une ou plusieurs résines époxy et/ou d'un ou plusieurs monomères,
(iii) une quantité efficace d'un ou plusieurs photo-initiateurs, et
(iv) une quantité efficace d'un ou plusieurs durcisseurs nucléophiles latents pour les résines époxy et/ou les monomères contenant une fonction époxy, ces durcisseurs étant choisis de manière à avoir une température de début de réaction de durcissement de l'époxy comprise entre 40 et 100°C lorsque l'adhésif est soumis à un balayage d'analyse calorimétrique différentielle à une vitesse de 20°C/min,

dans lequel les paramètres de solubilité sont calculés dans chaque cas selon la méthode de Fedors et sont exprimés en $(cal/cm^3)^{0,5}$ et dans lequel la somme des pourcentages massiques des constituants (i) - (iv) et, le cas échéant, des autres constituants et additifs, est égale à 100% en poids.

2. Précurseur selon la revendication 1, dans lequel le constituant photopolymérisable (i) du mode de réalisation (A) comprend en plus au moins 15%, par rapport à la masse du constituant (i), d'un ou plusieurs monomères à insaturation éthylénique copolymérisables ayant un paramètre de solubilité compris entre 9,5 et 10, et dans lequel les polymères ayant un paramètre de solubilité compris entre 10 et 12,5 du précurseur du mode de réalisation (B) ont une masse moléculaire Mp d'environ 50 000 - 500 000 g/mol.

3. Précurseur selon l'une quelconque des revendications 1 ou 2, dans lequel un ou plusieurs des composés durcisseurs sont choisis dans le groupe constitué par les composés de formule II

$$R - X_i \qquad II$$

dans laquelle R est un résidu organique monovalent ou multivalent, les radicaux $X_i$ sont, indépendamment les uns des autres, un groupe alkyle linéaire ou ramifié comportant au moins 8 atomes de C, où au moins un des groupes $-CH_2-$ est remplacé par un groupe -NH- et/ou qui présente un groupe terminal contenant N, qui contient au moins un atome de H actif, et i est un nombre entier de 1 à 4.

**4.** Précurseur selon l'une quelconque des revendications 1 - 3, dans lequel un ou plusieurs des monomères à insaturation éthylénique sont choisis dans le groupe constitué par les esters (méth)acryliques d'alcools non tertiaires et les composés à insaturation éthylénique contenant un atome de N.

**5.** Adhésif thermodurcissable sensible à la pression susceptible d'être obtenu par photopolymérisation du précurseur selon les revendications 1 - 4.

**6.** Adhésif thermodurcissable sensible à la pression selon la revendication 5, qui présente un pourcentage de réaction résiduelle d'au moins 90% après 8 semaines de stockage.

**7.** Adhésif thermodurci susceptible d'être obtenu par durcissement thermique de l'adhésif thermodurcissable sensible à la pression selon la revendication 5 ou 6.

**8.** Procédé pour lier une surface de matière plastique à une autre surface, comprenant les étapes consistant à

(i) intercaler une couche d'un adhésif thermodurcissable sensible à la pression selon l'une quelconque des revendications 5 ou 6 entre les deux surfaces, et
(ii) chauffer l'assemblage à une température supérieure à la température de début de réaction de durcissement de l'époxy.

**9.** Assemblage comprenant deux surfaces en matière plastique qui sont liées avec un adhésif thermodurci susceptible d'être obtenu par durcissement d'un précurseur selon l'une quelconque des revendications 1 - 4 à une température supérieure de moins de 100°C à la température de début de réaction de durcissement de l'époxy, pour donner une résistance au cisaillement du joint à recouvrement de l'assemblage d'au moins 3 MPa.

**10.** Assemblage comprenant au moins une surface en matière plastique que l'on obtient

(i) en intercalant une couche d'un adhésif thermodurcissable sensible à la pression selon l'une quelconque des revendications 5 ou 6 entre les deux surfaces, et
(ii) en chauffant l'assemblage à une température supérieure à la température de début de réaction de durcissement de l'époxy.

**Patentansprüche**

**1.** Photopolymerisierbarer Vorläufer eines wärmehärtbaren Haftklebstoffs, enthaltend

(i) etwa 30 bis etwa 80 Gew.-%, bezogen auf die Masse des Vorläufers, einer photopolymerisierbaren Komponente, bei der es sich um einen Monomer- oder Prepolymersirup handelt und die einen Gesamtlöslichkeitsparameter zwischen 10 und 11 aufweist und (A) mindestens 30 Gew.-%, bezogen auf die Masse der photopolymerisierbaren Komponente (i), eines oder mehrerer ethylenisch ungesättigter Monomere mit einem Löslichkeitsparameter zwischen 10 und 11,5 und weniger als 10 Gew.-%, bezogen auf die Masse der Komponente (i), eines oder mehrerer ethylenisch ungesättigter Monomere mit einem Löslichkeitsparameter von mehr als 11,5, oder (B) mindestens 50 Gew.-%, bezogen auf die Masse der photopolymerisierbaren Komponente (i), eines oder mehrerer ethylenisch ungesättigter Monomere mit einem Löslichkeitsparameter zwischen 9,5 und 11,5 und 10-30 Gew.-%, bezogen auf die Masse der photopolymerisierbaren Komponente (i), eines oder mehrerer ethylenisch ungesättigter Monomere mit einem Löslichkeitsparameter zwischen 11,5 und 12,5 enthält, mit der Maßgabe, daß im Fall (B) der Vorläufer zwischen 3 und 15 Gew.-%, bezogen auf die Masse des Vorläufers, eines oder mehrerer Polymere mit einem Löslichkeitsparameter von 10 bis 12,5 enthält,

(ii) etwa 20 bis etwa 70 Gew.-%, bezogen auf die Masse des Vorläufers, eines oder mehrerer Epoxidharze und/oder Epoxidmonomere,

(iii) eine wirksame Menge eines oder mehrerer Photoinitiatoren und

(iv) eine wirksame Menge eines oder mehrerer nucleophiler latenter Härter für die Epoxidharze und/oder Epoxidgruppen enthaltenden Monomere, die so ausgewählt sind, daß die Anspringtemperatur der Epoxidhärtungsreaktion zwischen 40 und 100°C liegt, wenn der Klebstoff einem DSC-Scan mit einer Rate von 20°C/min unterworfen wird,

wobei die Löslichkeitsparameter in jedem Fall nach der Methode von Fedor berechnet und in $(cal/cm^3)^{0,5}$ angegeben werden und die Massenprozentanteile der Komponenten (i)-(iv) und gegebenenfalls anderer Komponenten und Additive sich zu 100 Gew.-% addieren.

**2.** Vorläufer nach Anspruch 1, bei der die photocopolymerisierbare Komponente (i) der Ausführungsform (A) außerdem auch noch mindestens 15%, bezogen auf die Masse der Komponente (i), eines oder mehrerer copolymerisierbarer ethylenisch ungesättigter Monomere mit einem Löslichkeitsparameter zwischen 9,5 und 10 enthält und die Polymere mit einem Löslichkeitsparameter zwischen 10 und 12,5 des Vorläufers der Ausführungsform (B) ein Molekulargewicht Mw von etwa 50.000 bis 500.000 g/mol aufweisen.

**3.** Vorläufer nach Anspruch 1 oder 2, bei dem eine oder mehrere der Härterverbindungen aus der Gruppe von Verbindungen der Formel II

$$R - X_i \qquad \text{II}$$

worin R für einen ein- oder mehrwertigen organischen Rest steht, $X_i$ unabhängig voneinander für eine lineare oder verzweigte Alkylgruppe mit mindestens 8 C-Atomen, in der mindestens eine der $-CH_2$-Gruppen durch eine NH-Gruppe ersetzt ist und/oder die eine N-haltige Endgruppe aufweist, die mindestens ein aktives H-Atom enthält, steht und i für eine ganze Zahl von 1 bis 4 steht, stammen.

**4.** Vorläufer nach einem der Ansprüche 1-3, bei dem eines oder mehrere der ethylenisch ungesättigten Monomere aus der Gruppe bestehend aus (Meth)acrylsäureestern von nichttertiären Alkoholen und stickstoffhaltigen ethylenisch ungesättigten Verbindungen stammen.

**5.** Wärmehärtbarer Haftklebstoff, der durch Photopolymerisation des Vorläufers nach den Ansprüchen 1-4 erhältlich ist.

**6.** Wärmehärtbarer Haftklebstoff nach Anspruch 5, der einen prozentualen Restreaktionsanteil von mindestens 90% nach 8 Wochen Lagerung aufweist.

**7.** Wärmegehärteter Klebstoff, der durch thermisches Härten des wärmehärtbaren Haftklebstoffs nach Anspruch 5 oder 6 erhältlich ist.

**8.** Verfahren zum Verbinden einer Kunststoffoberfläche mit einer anderen Oberfläche, bei dem man

(i) zwischen den beiden Oberflächen sandwichartig eine Schicht eines wärmehärtbaren Haftklebstoffs nach Anspruch 5 oder 6 anordnet und

(ii) den Verbund auf eine oberhalb der Anspringtemperatur der Epoxidhärtungsreaktion liegende Temperatur erhitzt.

**9.** Verbund mit zwei Kunststoffoberflächen, die mit einem wärmegehärteten Klebstoff, der durch Härtung eines Vorläufers nach einem der Ansprüche 1-4 bei einer oberhalb der Anspringtemperatur der Epoxidhärtungsreaktion liegenden Temperatur von weniger als 100°C erhältlich ist, verbunden sind, wobei sich für den Verbund eine Überlappungsscherfestigkeit von mindestens 3 MPa ergibt.

**10.** Verbund mit mindestens einer Kunststoffoberfläche, der dadurch erhalten wird, daß man

(i) zwischen den beiden Oberflächen sandwichartig eine Schicht eines wärmehärtbaren Haftklebstoffs nach Anspruch 5 oder 6 anordnet und

(ii) den Verbund auf eine oberhalb der Anspringtemperatur der Epoxidhärtungsreaktion liegende Temperatur erhitzt.